(19) Europäisches Patentamt
European Patent Office
Office européen des brevets

(11) Veröffentlichungsnummer: **0 360 151**
**A2**

# (12) EUROPÄISCHE PATENTANMELDUNG

(21) Anmeldenummer: 89117005.2

(51) Int. Cl.5: G03F 7/029 , G03F 7/032

(22) Anmeldetag: 14.09.89

(30) Priorität: 19.09.88 DE 3831782

(43) Veröffentlichungstag der Anmeldung:
28.03.90 Patentblatt 90/13

(84) Benannte Vertragsstaaten:
DE FR GB

(71) Anmelder: HOECHST AKTIENGESELLSCHAFT
Postfach 80 03 20
D-6230 Frankfurt am Main 80(DE)

(72) Erfinder: Müller-Hess, Waltraud, Dr.
Lärchenstrasse 4
D-6200 Wiesbaden(DE)
Erfinder: Mohr, Dieter, Dr.
Eaubonner Strasse 8
D-6501 Budenheim(DE)
Erfinder: Frass, Werner, Dr.
Erbsenacker 37
D-6200 Wiesbaden-Naurod(DE)
Erfinder: Rode, Klaus, Dr.
Rua Dr. Wilhelm Scheele
CEP 08600-Suzano-SP(BR)

## (54) Photopolymerisierbares Gemisch und daraus hergestelltes Aufzeichnungsmaterial.

(57) Es wird ein photopolymerisierbares Gemisch beschrieben, das ein polymeres Bindemittel, das mindestens eine photooxydierbare Gruppe aufweist, einen Acryl- oder Alkacrylsäureester eines mehrwertigen Alkohols und eine Initiatorkombination aus einem photoreduzierbaren Farbstoff und einer durch Strahlung spaltbaren Trihalogenmethylverbindung enthält.

Das Gemisch ist zur Herstellung von Druckplatten und Photoresists hoher Lichtempfindlichkeit im ultravioletten und sichtbaren Spektralbereich geeignet.

EP 0 360 151 A2

## Photopolymerisierbares Gemisch und daraus hergestelltes Aufzeichnungsmaterial

Die Erfindung betrifft ein photopolymerisierbares Gemisch, das ein polymeres Bindemittel, eine polymerisierbare Verbindung mit mindestens einer Acryl- oder Alkacrylsäureestergruppe im Molekül sowie eine Photoinitiatorkombination enthält.

Photopolymerisierbare Gemische, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten, sind bekannt. Derartige synergistisch wirkende Gemische sind z. B. in den DE-A 26 02 419 und 22 51 048 und der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können. Andere Gemische ähnlicher Zusammensetzung polymerisieren bereits im Dunklen und haben deshalb eine unzureichende Lagerfähigkeit.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (USA 3 097 096, EP-A 14 293 und 97 012). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln, z. B. Organometall-, Organophosphin-, Organoarsin- und Schwefelverbindungen oder Heterocyclen, sind in den US-A 3 488 269, 3 573 922, 3 597 343 und 3 649 495 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

Es sind ferner photopolymerisierbare Gemische mit polymeren Bindemitteln, die Aminogruppen enthaltende Einheiten aufweisen, bekannt. In der GB-A 2 171 107 wird ein Gemisch beschrieben, das ein derartiges Bindemittel in Kombination mit Monomeren enthält, die freie Säuregruppen aufweisen und mit den Aminogruppen Salze bilden können. Das Gemisch liefert Druckplatten mit guter Resistenz gegen wäßrige Druckfarben. Ähnliche Gemische sind in der US-A 2 893 868 beschrieben.

Aus der DE-A 3 131 448 sind photopolymerisierbare Gemische bekannt, die als Bindemittel Vinylpolymere mit eingebauten Amino- oder Iminogruppen enthalten. Durch diese Bindemittel soll die Haftung auf Kupfer verbessert werden, ohne daß dadurch die Lagerfähigkeit oder der Belichtungsspielraum beeinträchtigt wird.

In der JP-A 54/151 024 ist ein photopolymerisierbares Gemisch beschrieben, das eine Initiatorkombination aus einem Merocyaninfarbstoff und einem trihalogenmethylsubstituierten s-Triazin enthält und gegenüber sichtbarem Licht, z. B. einem Argonlaser, empfindlich ist. Die Empfindlichkeit dieser Gemische gegenüber sichtbarem Laserlicht ist jedoch für eine wirtschaftliche Nutzung nicht ausreichend.

In den älteren deutschen Patentanmeldungen P 37 10 279.6, P 37 10 281.8 und P 37 10 282.6 werden photopolymerisierbare Gemische vorgeschlagen, die polymere Bindemittel, polymerisierbare Acryl- oder Alkacrylsäureester, die photooxydierbare Gruppen aufweisen, und Photoinitiatoren oder Photoinitiatorkombinationen, insbesondere photoreduzierbare Farbstoffe und ggf. bestimmte lichtempfindliche Trichlormethylverbindungen sowie ggf. weitere radikalbildende Coinitiatoren enthalten. Diese Gemische zeichnen sich durch eine hohe Lichtempfindlichkeit aus.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich auszeichnen und daher insbesondere zur Laserstrahlaufzeichnung im sichtbaren Bereich geeignet sind und die sich mit schwach alka lischen Lösungen ohne Zusatz organischer Lösemittel entwickeln lassen.

Erfindungsgemäß wird ein photopolymerisierbares Gemisch vorgeschlagen, das als wesentliche Bestandteile

a) ein polymeres Bindemittel,

b) einen Acryl- oder Alkacrylsäureester eines mehrwertigen Alkohols und

c) eine Verbindungskombination enthält, die unter Einwirkung von aktinischer Strahlung die Polymerisation der Verbindung (b) zu initiieren vermag.

Das erfindungsgemäße Gemisch ist dadurch gekennzeichnet, daß die Verbindungskombination (c)

c1) einen photoreduzierbaren Farbstoff und

c2) eine durch Strahlung spaltbare Trihalogenmethylverbindung enthält und daß das Bindemittel (a) mindestens eine photooxydierbare Gruppe aufweist.

Als photooxydierbare Gruppen kommen insbesondere Aminogruppen, Thiogruppen, die auch Bestandteile heterocyclischer Ringe sein können, und Stannylgruppen in Betracht. Beispiele für derartige Gruppen sind Dimethylaminoethyl-, N′-Methyl-piperazinopropyl-, 2-(4-Methylthiazol-5-yl)ethyl-, Methylthiomethyl-und 3-Trimethylstannyl-propylgruppen. Polymere mit tertiären Aminogruppen und Stannylgruppen werden bevorzugt.

Insbesondere werden Copolymere eingesetzt, die Einheiten von (Meth)acrylsäureestern oder -amiden, von alkenylaromatischen Verbindungen, von Itaconsäurederivaten oder von Maleinsäurederivaten enthalten, die jeweils mindestens eine der genannten photooxydierbaren Gruppen aufweisen. Als Comonomere werden mit diesen Verbindungen copolymerisierbare Vinylverbindungen eingesetzt, die dem Polymeren weitere gewünschte Eigenschaften, wie Alkalilöslichkeit, Flexibilität und Filmbildungsvermögen verleihen. Beispiele für geeignete Comonomere sind (Meth)acrylsäureester, $\alpha,\beta$-ungesattigte Carbonsäuren, Alkenylaromaten, basische Vinylheterocyclen, Vinylhalogenide, Vinylester, Vinylketone und Vinylether.

Mit besonderem Vorteil werden Polymere eingesetzt, die Einheiten enthalten, die von mindestens einem der folgenden Monomeren $A^1$, $A^2$, $A^4$ und $A^4$ abgeleitet sind:

$A^1$)

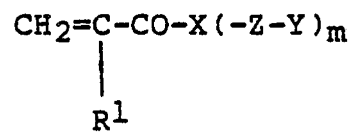

(I)

worin $R^1$ ein Wasserstoffatom, eine Methyl- oder Ethylgruppe ist,

X O, NH oder $NR^2R^3$ bedeutet, wobei $R^2$ und $R^3$ voneinander unabhängig für Alkylreste mit 1 bis 18 Kohlenstoffatomen, die linear, verzweigt oder cyclisch sind und Halogen-, Schwefel-, Sauerstoff- oder Stickstoffatome enthalten können, oder für Phenyl- oder $C_1$-$C_4$-Alkylphenylreste stehen, die ggf., z. B. durch Alkoxygruppen oder Halogenatome, substituiert sein können. $R^2$ und $R^3$ können auch unter Bildung eines N-heterocyclischen Rings miteinander verbunden sein. Sie bilden bevorzugt 5- bis 7-gliedrige N-heterocyclische Ringe mit ggf. weiteren Heteroatomen.

Z ist eine Alkylengruppe mit bevorzugt 1 bis 10 Kohlenstoffatomen, die analog $R^2$ und $R^3$ aufgebaut bzw. substituiert sein kann, oder eine Phenylengruppe, die unsubstituiert oder substituiert sein kann, insbesondere durch Alkyl- oder Alkoxygruppen mit 1 bis 4 Kohlenstoffatomen, Alkoxycarbonylgruppen mit 2 bis 5 Kohlenstoffatomen oder Halogenatome. Z kann auch eine Gruppe folgender Struktur sein:

$-C_nH_{2n}-OCO-NH-Z^1-NH-COQ-R^2-$,

wobei n Werte von 1 bis 4 annehmen kann, $R^2$ die oben angegebene Bedeutung hat,

$Z^1$ eine Kohlenwasserstoffgruppe mit 2 bis 12 Kohlenstoffatomen, insbesondere eine Tolylen-, Cyclohexylen-, Trimethylcyclohexylenmethylen-, Hexamethylen- oder Trimethylhexamethylengruppe und Q für O oder NH steht.

Y ist eine der Gruppen $-NR^2R^3$, $-SnR^4{}_3$, $-SR^4$ oder ein 5- oder 6-gliedriger heteroaromatischer Rest mit bis zu zwei S-, O- oder N-Atomen und - im Falle von Z = Alkylen - auch ein heteroaromatischer Rest mit fünf oder sechs Ringatomen und bis zu drei O-, N- oder S-Atomen, wobei $R^4$ eine Alkylgruppe mit 1 bis 10, vorzugsweise 1 bis 4, Kohlenstoffatomen sein kann und $R^2$ und $R^3$ die oben angegebene Bedeutung haben,

m ist je nach Wertigkeit von X 0 oder 1.

$A^2$) hat die Formel II

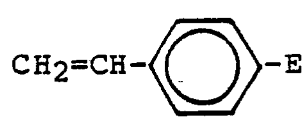

(II),

worin E für eine Gruppe $NR^5{}_2$ steht, in der $R^5$ ein Alkylrest mit 1 bis 10 Kohlenstoffatomen ist, der verzweigt oder linear sein kann, wobei beide Reste $R^5$ gleich oder verschieden sein können. E kann ferner eine Alkylgruppe mit 1 bis 6 Kohlenstoffatomen sein, die mit mindestens einer Gruppe $NR^6{}_2$ substituiert ist, wobei $R^6$ die Bedeutung von $R^5$ hat und zusätzlich ein Arylrest, insbesondere ein Phenylrest oder ein heterocyclischer Rest mit 1 oder 2 Heteroatomen wie N, O oder S sein kann.

$A^3$) ist ein Itaconsäurederivat der Formel III

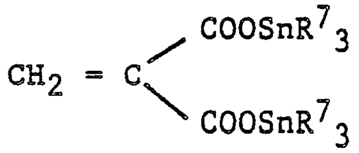 (III)

und

A4) ein Maleinsäurederivat der Formel IV

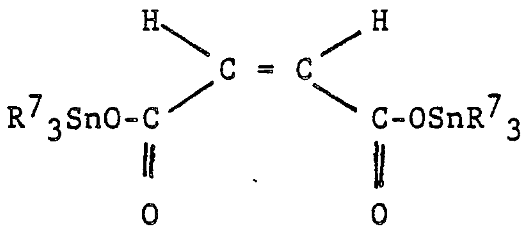 (IV)

$R^7$ ist in beiden Formeln eine lineare oder verzweigte Alkylgruppe mit 1 bis 6 Kohlenstoffatomen, wobei in jedem Rest die Gruppen $R^7$ untereinander gleich oder verschieden sein können.

Als Comonomere finden Vinylmonomere Einsatz wie Ester der (Meth)acrylsäure mit aliphatischen oder cycloaliphatischen Alkoholen mit 1 bis 20 Kohlenstoffatomen oder aromatischen Alkoholen mit 7 bis 12 Kohlenstoffatomen, die ggf. durch Halogenatome substituiert sein können, z. B. Methyl-, Ethyl-, n-Butyl-, iso-Butyl-, n-Amyl-, Pentyl-, Hexyl-, Cyclohexyl-, 2-Methylpentyl-, Heptyl-, Octyl-, 2-Ethylhexyl-, Decyl-, Dodecyl-, Tetradecyl-, Hexadecyl(meth)acrylat, Benzyl(meth)acrylat oder 2,2,3,3-Tetrafluorpropyl(meth)-acrylat. Die verwendeten Bindemittel können eine oder mehrere dieser Ester enthalten.

Comonomere, die saure Gruppen tragen, sind z. B. (Meth)acrylsäure, Itaconsäure, Crotonsäure und andere. Beispiele für vinylaromatische Monomere sind Styrol, Alkylstyrole wie Methylstyrol, Ethylstyrol; halogenierte Styrole wie Chlorstyrol, Bromstyrol; Alkoxystyrole wie Methoxystyrol, Ethoxystyrol; Hydroxystyrole, Carboxystyrole und Derivate, wie Methylvinylbenzoat, mehrfach substituierte Styrole, wie 2,4-Dimethylstyrol und schwefelhaltige Styrole, wie Vinylbenzolsulfonat.

Als basische Comonomere werden z. B. Vinylpyridin, Vinylimidazol und Vinylpyrrolidon eingesetzt. Ferner finden Vinylmonomere mit Urethan- oder Sulfonylurethangruppen, wie Methacrylsäure-2-hydroxyethyl-N-methylurethan, -N-p-toluolsulfonylurethan, -N-propenyl-sulfonylurethan Verwendung. Weiterhin können Vinylhalogenide, Vinylester, z. B. Vinylacetat, Vinylketone oder andere hier nicht aufgeführte Monomere mit den Komponenten ($A^1$), ($A^2$, ($A^3$) und ($A^4$) copolymerisiert werden.

Bevorzugte Comonomere sind (Meth)acrylsäure und Styrol und deren Derivate. Der Gehalt der Copolymeren an Einheiten ($A^1$), ($A^2$), ($A^3$) oder ($A^4$) beträgt 0,5 bis 95, bevorzugt 5 bis 80 mol-%, und der Gesamtgehalt von 100 mol-% wird durch die oben beschriebenen und mit den Monomeren ($A^1$) bis ($A^4$) copolymerisierbaren Vinylmonomeren erreicht.

Spezifische Beispiele für erfindungsgemäß als Bindemittel bevorzugte Polymere sind in der Tabelle 1 angegeben. Diese Polymeren lassen sich nach bekannten Polymerisationsmethoden herstellen, beispielsweise durch Polymerisation in der Masse, in Lösung oder Suspension. Als Starter werden i. a. Peroxide oder Azoverbindungen verwendet. Das Molekulargewicht der Polymeren kann leicht nach bekannten Methoden reguliert werden, beispielsweise durch Variation von Initiatorkonzentration, Polymerisationstemperatur, Monomerkonzentration oder durch Zugabe von Molekulargewichtsreglern.

Tabelle 1

| Verbindung | Zusammensetzung |
|---|---|
| 1 | Methacrylsäure/Styrol/n-Hexylmethacrylat/1,3-Bis-dimethylamino-2-methacryloyloxypropan 10/30/20/40 |

Tabelle 1 (Fortsetzung)

| Verbindung | Zusammensetzung |
|---|---|
| 2 | Methacrylsäure/Styrol/n-Hexylmethacrylat/ 4-(2-Methacryloyloxy-ethyl)-morpholin 10/30/20/40 |
| 3 | Methacrylsäure/Styrol/n-Hexylmethacrylat/ 2-Diethylamino-ethylmethacrylat 10/30/20/40 |
| 4 | Methacrylsäure/Styrol/n-Hexylmethacrylat/ 2-Dimethylamino-ethylmethacrylat 10/30/20/40 |
| 5 | Methacrylsäure/Styrol/n-Hexylmethacrylat/ 1-Methyl-2-methacryloyloxymethyl-piperidin 10/30/20/40 |
| 6 | Methacrylsäure/Styrol/n-Hexylmethacrylat/ 1-(2-Methacryloyloxy-ethyl)-piperidin 10/30/30/30 |
| 7 | Methacrylsäure/Styrol/n-Hexylmethacrylat/ 4-Methyl-1-(3-Methacryloyloxy-propyl)-piperazin 10/30/20/40 |
| 8 | Methacrylsäure/Styrol/n-Hexylmethacrylat/ 2-Diethylamino-ethylacrylat 10/30/20/40 |

Tabelle 1 (Fortsetzung)

| Verbindung | Zusammensetzung |
|---|---|
| 9 | Methacrylsäure/Styrol/n-Hexylmethacrylat/ Tributylstannylmethylmethacrylat 30/10/30/30 |
| 10 | Methacrylsäure/Styrol/n-Hexylmethacrylat/ 2-(Trimethylstannyl)-prop-2-ylmethacrylat 30/10/30/30 |
| 11 | Methacrylsäure/n-Hexylmethacrylat/ 5-(2-Methacryloyloxy-ethyl)-4-methyl-thiazol 20/40/40 |
| 12 | Methacrylsäure/n-Hexylmethacrylat/ Methylthiomethylmethacrylat 10/50/40 |
| 13 | Methacrylsäure/Styrol/n-Hexylmethacrylat/ N-(3-Dimethylamino-propyl)-methacrylamid 20/20/30/30 |
| 14 | Methacrylsäure/Styrol/n-Hexylmethacrylat/ N-tert-Butylmethacrylamid 20/20/30/30 |
| 15 | Methacrylsäure/Methylmethacrylat/ Bis-(tri-n-butylstannyl)maleinat 10/40/50 |
| 16 | Methacrylsäure/Methylmethacrylat/ 4-Vinyl-1-(2-diethylamino-ethyl)-benzol 20/30/50 |

Tabelle 1 (Fortsetzung)

| Verbindung | Zusammensetzung |
|---|---|
| 17 | Methacrylsäure/Styrol/n-Hexylmethacrylat/Acrylsäure-4-methyl-piperazid 10/20/30/40 |
| 18 | Styrol/2-Dimethylamino-ethylmethacrylat 20/80 |
| 19 | Methacrylsäure/n-Hexylmethacrylat/2-Diethylamino-ethylmethacrylat 30/50/20 |
| 20 | Styrol/2-Dimethylamino-ethylmethacrylat 30/70 |
| 21 | Methacrylsäure/n-Hexylmethacrylat/2-Diethylamino-ethylmethacrylat 10/60/30 |
| 22 | Methacrylsäure/Styrol/n-Hexylmethacrylat/2-Diethylamino-ethylmethacrylat 10/15/40/35 |
| 23 | Methacrylsäure/Styrol/n-Hexylmethacrylat/2-Diethylamino-ethylmethacrylat 10/30/25/35 |
| 24 | Methacrylsäure/Styrol/n-Hexylmethacrylat/2-Diethylamino-ethylmethacrylat 10/40/20/30 |
| 25 | Methacrylsäure/Styrol/n-Hexylmethacrylat/2-Diethylamino-ethylmethacrylat 10/30/40/20 |
| 26 | Methacrylsäure/Styrol/2-Dimethylamino-ethylmethacrylat/Methylaminocarbonyloxyethylmethacrylat 10/10/30/50 |

Tabelle 1 (Fortsetzung)

| Verbindung | Zusammensetzung |
|---|---|
| 27 | Methacrylsäure/Styrol/2-Dimethylamino-ethylmethacrylat/5-(2-Methacryloyloxy-ethyl)-4-methyl-thiazol 15/15/40/20 |
| 28 | Methacrylsäure/Methylthiomethylmethacrylat 15/85 |
| 29 | Methacrylsäure/Styrol/n-Hexylmethacrylat/2-Dimethylamino-ethylmethacrylat 15/10/60/15 |
| 30 | Methacrylsäure/Styrol/n-Hexylmethacrylat/2-Dimethylamino-ethylmethacrylat 25/10/60/5 |
| 31 | Methacrylsäure/Styrol/n-Hexylmethacrylat/2-Dimethylamino-ethylmethacrylat 30/9/60/1 |
| 32 | Methacrylsäure/Methylmethacrylat/2-Dimethylamino-ethylmethacrylat 10/70/20 |
| 33 | Methacrylsäure/Styrol/Methylmethacrylat/2-Dimethylamino-ethylmethacrylat 10/30/20/40 |
| 34 | Methacrylsäure/Styrol/Ethylacrylat/2-Diethylamino-ethylacrylat 10/30/20/40 |
| 35 | Acrylsäure/Styrol/Ethylacrylat/2-Diethylamino-ethylacrylat 10/30/20/40 |

Tabelle 1 (Fortsetzung)

| Verbindung | Zusammensetzung |
|---|---|
| 36 | Acrylsäure/Styrol/n-Hexylmethacrylat/ 2-Diethylamino-ethylacrylat 10/30/20/40 |
| 37 | Acrylsäure/Styrol/Methylmethacrylat/ 2-Dimethylamino-ethylmethacrylat 10/30/20/40 |
| 38 | Acrylsäure/Styrol/2-Ethyl-hexylacrylat/ 2-Diethylamino-ethylmethacrylat 10/30/20/40 |
| 39 | Methacrylsäure/Styrol/Ethylacrylat/ 2-Diethylamino-ethylmethacrylat 10/30/20/40 |
| 40 | Methacrylsäure/Benzylmethacrylat/2-Diethylamino-ethylmethacrylat 10/50/40 |
| 41 | Acrylsäure/Styrol/Ethylacrylat/2-Diethylamino-ethylmethacrylat 10/30/20/40 |
| 42 | Methacrylsäure/Methylmethacrylat/2-Dimethylamino-ethylmethacrylat 10/40/50 |

Die Monomeren der Struktur ($A^1$), ($A^2$), ($A^3$) oder ($A^4$) werden bevorzugt mit (Meth)acrylsäure, einer Styrolverbindung und/oder einem (Meth)acrylsäureester copoly merisiert, wobei jedes Monomer ($A^1$) bis ($A^4$) für sich allein oder in allen denkbaren Mischungen mit den übrigen eingesetzt werden kann. Die Säurekomponente ist für die Entwickelbarkeit mit schwach alkalischen wäßrigen Lösungen verantwortlich; ihr Anteil beträgt im allgemeinen 0 bis 40, vorzugsweise 5 bis 30 mol-%. Der Anteil an Styrolverbindung und (Meth)acrylat beträgt jeweils 0 bis 80, vorzugsweise 5 bis 60 mol-%. Diese Komponenten verleihen dem Bindemittel Resistenz gegen die bei der Entwicklung eingesetzten wäßrig-alkalischen Lösungen und ferner Beständigkeit gegenüber anderen Chemikalien. Weiterhin wird durch diese Monomeren die Weichheit der Schicht eingestellt und die Haftung auf den verwendeten Trägermaterialien bewirkt.

Der Anteil an ungesättigter Säure hängt stark von der restlichen Zusammensetzung des Polymeren ab. Der Anteil an Styrolverbindung beträgt im allgemeinen 0 bis 60, bevorzugt 5 bis 45 mol-%, der Anteil an (Meth)acrylsäureester liegt im allgemeinen bei 10 bis 70 mol-%. Das photooxydierbare Monomere hat im allgemeinen einen Mengenanteil von 5 bis 80, vorzugsweise von 20 bis 50 mol-%. Unterhalb von 5 Molprozent ist die gewünschte Lichtempfindlichkeit zu gering, während ein Gehalt von über 80 Molprozent zur Klebrigkeit der Schichten oder aber zu Entwicklungsschwierigkeiten führen kann. Die Summe der Anteile von Styrolverbindung und (Meth)acrylsäureester liegt vorzugsweise bei 40 bis 70 mol.-%.

Das Gewichtsmittel des Molekulargewichts der Copolymeren beträgt gewöhnlich 5.000 bis 1.000.000, vorzugsweise 10.000 bis 500.000. Besonders bevorzugt ist ein mittleres Molekulargewicht von etwa 10.000 bis 250.000.

Die Verbindungen der Formel ($A^1$) werden nach bekannten Methoden aus (Meth)acrylsäureanhydrid oder -chlorid durch Umsetzung mit dem entsprechenden disubstituierten Aminoalkohol, Stannan, Aminoamin, heterocyclischen Alkohol oder Monochlordialkylsulfid hergestellt. Beispiele für derartige Umsetzungskomponenten sind Diethylaminoethanol, N-(2-Hydroxyethyl)-morpholin, N-(2-Hydroxyethyl)-piperidin, 1,3-Bis-(dimethylamino)-propanol-2, N-Hydroxypropyl-N′-methyl-piperazin, 3-Hydroxy-chinuclidin, 2-Hydroxymethyl-N-methyl-piperidin, 5-(2-Hydroxyethyl)-4-methyl-thiazol, Monochlordimethylsulfid, Trimethylstannylmethanol, 2-(Trimethylstannyl)-propan-2-ol und Tributylstannylmethanol. Außerdem werden Verbindungen der Formel ($A^1$) durch Umsetzung von Hydroxyalkyl(meth)acrylaten mit aliphatischen oder aromatischen, am Stickstoffatom disubstituierten Aminosäurechloriden oder durch Umsetzung von aromatischen oder cycloaliphatischen Diisocyanaten, die unterschiedlich reaktive Isocyanatgruppen besitzen, mit Aminoalkylphenolen und danach mit Hydroxyalkyl(meth)acrylaten und danach mit Dialkylaminoaminen oder Dialkylaminoalkoholen erhalten.

Verbindungen der Formel ($A^2$) werden nach bekannten Synthesevorschriften durch Dehydratisierung von Dialkylamino-hydroxyethylbenzolen oder durch Addition von sekundären Aminen an Divinylbenzol oder durch Umsetzung von 4-Bromalkyl-vinylbenzol mit sekundären Aminen hergestellt.

Die Herstellung der Monomeren ($A^1$) und ($A^2$) wird zweckmäßig in inerten Lösungsmitteln durchgeführt. Zur thermischen Stabilisierung der stark zur Polymerisation neigenden Produkte werden Hydrochinone und Hydrochinonether, vorzugsweise tert-Butylbrenzkatechin oder 2,6-Di-tert-butyl-p-cresol in Konzentrationen von 0,01 bis 2,0 Gewichtsprozent zugesetzt.

Verbindungen der Formeln ($A^3$) und ($A^4$) werden durch Umsetzung von Trialkylzinnoxiden mit Itaconsäure- bzw. Maleinsäureanhydrid hergestellt.

Außer den beschriebenen photooxydierbaren polymeren Bindemitteln können auch herkömmliche, durch polymeranaloge Reaktionen abgeänderte Bindemittel eingesetzt werden. Ein derartiges, leicht zu modifizierendes Polymeres ist z. B. ein Styrol-Maleinsäureanhydrid-Copolymeres, bevorzugt mit einem Molekulargewicht von 10.000 bis 400.000, das mit aminogruppenhaltigen Alkoholen, wie Dimethylaminoalkohol oder 1,3-Bis-dimethylamino-2-propanol, oder mit primären oder sekundären Aminen umgesetzt werden kann. Es entstehen Halbester, Halbamide oder im Falle der primären Amine auch Imide.

Weitere Beispiele für modifizierbare Polymere sind Vinylacetat-Vinylalkohol-Copolymere mit mindestens 80 Prozent Vinylalkoholeinheiten und mittleren Molekulargewichten von 3.000 bis 150.000 oder darüber, bevorzugt von 20.000 bis 100.000. Von den handelsüblichen Polyvinylalkoholen werden solche mit 88 bis 98 Prozent Verseifungsgrad und K-Werten von 4 bis 20 bevorzugt. Auch Polyvinylbutyrale mit einem Acetalgehalt von 69 bis 85 Prozent, einem Restacetatgehalt von 1 bis 5 Prozent und einem Hydroxylgruppengehalt von 10 bis 30 Prozent werden durch polymeranaloge Reaktionen umgesetzt. Die Molekulargewichte der Polyvinylbutyrale entsprechen denen der oben genannten Vinylacetat-Vinylalkohol-Copolymeren. Diese Polymeren werden mit aromatischen oder aliphatischen Aminoaldehyden umgesetzt. Als Aldehydkomponenten kommen z. B. p-Dimethylaminobenzaldehyd oder 3-Diethylamino-2,2-dimethyl-propionaldehyd in Frage. Beispiele für derartige Bindemittel sind in Tabelle 2 aufgeführt.

Tabelle 2

| Verbindung | Ausgangspolymeres | Reaktionskomponente | Verhältnis der reaktiven Gruppen von Polymerem zur Reaktionskomponente |
|---|---|---|---|
| A | Styrol-Maleinsäureanhydridcopolymeres | Dicyclohexylamin | 1 : 2 |
| B | Styrol-Maleinsäureanhydridcopolymeres | Dimethylaminoneopentylamin | 1 : 2 |
| C | Styrol-Maleinsäureanhydridcopolymeres | 1,3-Bis-(dimethylamino)-propan-2-ol | 1 : 2 |
| D | Styrol-Maleinsäureanhydridcopolymeres | Bis-(4-dimethylaminophenyl)carbinol | 1 : 2 |
| E | Styrol-Maleinsäureanhydridcopolymeres | 2-Diethylamino-ethylamin | 1 : 2 |
| F | Vinylacetat-Vinylalkohol-Copolymeres | Isobutyraldehyd + p-Dimethylaminobenzaldehyd | 1 : 0,2 : 0,37 |
| G | Vinylacetat-Vinylalkohol-Copolymeres | Isobutyraldehyd + 3-Diethylamino-2,2-dimethyl-propionaldehyd | 1 : 0,2 : 0,29 |

Zusätzlich zu den vorstehend beschriebenen Polymeren mit photooxydierbaren Gruppen können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit Vorteil sollten auch diese Bindemittel wasserunlöslich, aber in wäßrig-alkalischen Lösungen löslich oder mindestens quellbar sein.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a..

Die Gesamtmenge an Bindemitteln beträgt im allgemeinen 20 bis 90, vorzugsweise 30 bis 80 Gew.-% der Bestandteile des Gemischs.

Die erfindungsgemäßen Gemische und Materialien enthalten polymerisierbare (Alk)acrylsäureester mit mindestens einer endständigen ethylenischen Doppelbindung. Als polymerisierbare Verbindungen werden bevorzugt Ester der Acryl- oder Methacrylsäure mit ein- oder mehrwertigen, vorzugsweise primären, Alkoholen verwendet. Vorzugsweise sollten die polymerisierbaren Verbindungen mehr als eine, insbesondere 2 bis 4, polymerisierbare Gruppen enthalten. Beispiele für geeignete mehrwertige Alkohole sind Ethylenglykol, Propylenglykol, Butandiol-1,4, Butandiol-1,3, Diethylenglykol, Triethylenglykol oder Polypropylenglykole mit Molekulargewichten von etwa 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Besonders geeignet sind Urethangruppen enthaltende Bisacrylate und Bismethacrylate, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben. Zusätzlich zu den genannten Estern können auch Amide von Acryl- oder Methacrylsäure eingesetzt werden. Beispiele sind Methylenbis-(meth)acrylamid, Ethylenbis-(meth)acrylamid und m-Xylylenbis-(meth)acrylamid.

Der Mengenanteil des Gemischs an Monomeren beträgt im allgemeinen etwa 20 bis 80, vorzugsweise 30 bis 70 Gew.-% der nichtflüchtigen Bestandteile.

Das erfindungsgemäße Gemisch enthält als Photoinitiatorbestandteil einen photoreduzierbaren Farbstoff (c1). Geeignete Farbstoffe sind insbesondere Xanthen-, Thiazin-, Pyronin, Porphyrin- oder Acridinfarbstoffe. Bevorzugte Vertreter der Xanthenfarbstoffe sind Verbindungen der allgemeinen Formel V

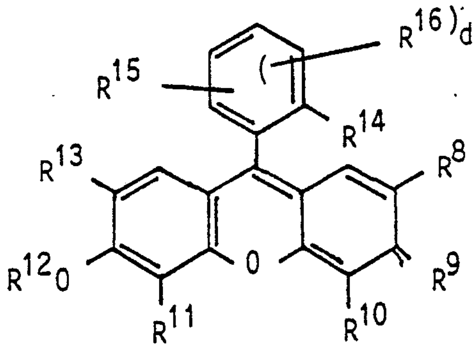

(V)

worin

$R^8$ und $R^{13}$ gleich oder verschieden sind und Wasserstoff oder Halogenatome, Nitro- oder Hydroxygruppen oder Gruppen der Formel -HgOH bedeuten,

$R^{10}$ und $R^{11}$ gleich oder verschieden sind und Wasserstoff- oder Halogenatome oder Hydroxygruppen,

$R^9$ O oder $^{(+)}$NHAlkyl $An^{(-)}$,

$R^{12}$ ein Wasserstoffatom, Alkalimetall-, Ammonium- oder Trialkylammoniumkation, eine Alkyl- oder Acylgruppe,

$R^{14}$ ein Wasserstoffatom oder eine Gruppe $COOR^{17}$,
$R^{15}$ ein Wasserstoff- oder Halogenatom oder eine Aminogruppe,
$R^{16}$ ein Wasserstoff- oder Halogenatom,
$R^{17}$ ein Wasserstoffatom, ein Alkalimetall- oder Ammoniumkation, eine Alkylgruppe oder ein polymerer Rest,
An ein Anion und
d Null oder eine ganze Zahl von 1 bis 3 bedeutet.

Wenn die Reste $R^9$, $R^{12}$ und $R^{17}$ Alkylreste sind oder solche enthalten, haben diese im allgemeinen 1 bis 25, insbesondere 1 bis 18 Kohlenstoffatome.

Geeignete Thiazinfarbstoffe sind Verbindungen der Formel VI und geeignete Pyroninfarbstoffe Verbindungen der Formel VII

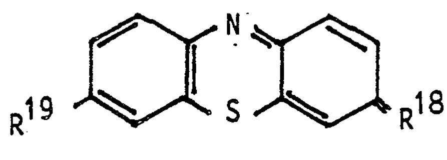
(VI)

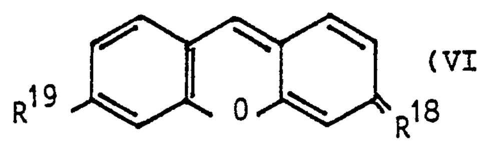
(VII)

worin
$R^{18}$ eine der Gruppen $=NH_2^{(+)}\ An^{(-)}$, $=NHAlkyl^{(+)}\ An^{(-)}$ und $=N(Alkyl)_2^{(+)}\ An^{(-)}$,
$R^{19}$ eine Amino-, Alkylamino- oder Dialkylaminogruppe und
An ein Anion ist.

In den Formeln VI und VII haben Alkylgruppen die gleiche Bedeutung wie in der Formel V.

Als Porphyrinfarbstoff ist z. B. Hämatoporphyrin und als Acridinfarbstoff z. B. Acriflaviniumchlorid-Hydrochlorid geeignet. Beispiele für Verbindungen der Formel V sind Eosin B (C.I. Nr. 45 400), Eosin J (C.I. Nr. 45 380), Eosin alkohollöslich (C.I. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Verbindungen der Formel VI sind Thionin (C.I. Nr. 52 000), Azur A (C.I. Nr. 52 005) und Azur C (C.I. Nr. 52 002).

Beispiele für Farbstoffe der Formel VII sind Pyronin B (C.I. Nr. 45 010) und Pyronin GY (C.I. Nr. 45 005). Die Menge der Komponente (c1) des Gemischs liegt im allgemeinen zwischen 0,01 und 10, vorzugsweise zwischen 0,05 und 4 Gew.-%, bezogen auf die nichtflüchtigen Anteile des Gemisches.

Zur Steigerung der Lichtempfindlichkeit enthalten die erfindungsgemäßen Gemische Verbindungen mit photolytisch spaltbaren Trihalogenmethylgruppen (c2), die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet.

Die Komponenten (c2) werden im allgemeinen in einer Menge von 0,01 bis 10, vorzugsweise von 0,05 bis 6 Gew.-%, bezogen auf die nichtflüchtigen Bestandteile des Gemischs, eingesetzt.

Die erfindungsgemäßen Gemische enthalten als weiteren Initiatorbestandteil eine Acridin-, Phenazin-, 1,2-Benzanthrachinon- oder Chinoxalinverbindung (d). Diese Verbindungen sind als Photoinitiatoren bekannt und in den DE-C 20 27 467 und 20 39 861 und der US-A 3 046 127 beschrieben. Durch diese Verbindungen wird die Empfindlichkeit des Gemischs vor allem im nahen Ultraviolettbereich gesteigert. Geeignete Vertreter dieser Verbindungsklasse sind in der genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet.

Als Chinoxalinderivate kommen insbesondere die 2,3-Diphenylderivate in Betracht, die vorzugsweise in den beiden Phenylresten durch Methoxygruppen weiter substituiert sind. Im allgemeinen werden als Komponenten (d) die Acridinderivate bevorzugt.

Die Menge der Komponente (d) im Gemisch liegt ebenfalls im Bereich von 0,01 bis 10 Gew.-%, vorzugsweise zwischen 0,05 und 5 Gew.-%.

Wenn eine weitere Empfindlichkeitssteigerung des Gemischs im sichtbaren Spektralbereich erwünscht ist, kann diese durch Zusatz einer Verbindung (e) vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4′-disubstituierte Dibenzalacetone, z. B. 4-Diethylamino-4′-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge der Verbindung (e) liegt ebenfalls im Bereich von 0,01 bis 10, vorzugsweise von 0,05 bis 4 Gew.-%, bezogen auf die nichtflüchtigen Bestandteile des Gemischs.

Die Gesamtmenge an Polymerisationsinitiatoren (c1), (c2) und (d) oder ggf. die Gesamtmenge einschließlich der Komponente (e) liegt im allgemeinen bei 0,05 bis 20, vorzugsweise bei 0,1 bis 10 Gew.-%. Das Molverhältnis der Bestandteile (c1), (c2), (d) und (e) untereinander liegt bevorzugt in den folgenden Bereichen

$(c^1) : (c^2) : (d) : (e) = 1 : (4\text{-}10) : (1\text{-}5) : (0\text{-}4)$.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckplatten, vorliegen. Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.. Solche Deckschichten haben im allgemeinen eine Dicke von 0,1 bis 10, vorzugsweise 1 bis 5 µm.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösungsmittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat laminiert.

Durch die breite spektrale Empfindlichkeit des erfindungsgemäßen Gemisches können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels digitaler Daten aus einem Datenspeicher moduliert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Die polymeren Verbindungen der Tabelle 1 werden in den nachfolgenden Beispielen in erfindungsgemäßen Aufzeichnungsmaterialien als Bindemittel eingesetzt. In den Beispielen stehen Gewichtsteile (Gt) und Volumenteile (Vt) im Verhältnis von g zu ccm. Prozent- und Mengenverhältnisse sind, wenn nicht anders angegeben, in Gewichtseinheiten zu verstehen.

In den Beispielen 1 bis 3 werden die in der Tabelle 1 aufgeführten Polymerisate jeweils in demselben Beschichtungsgemisch ausgetestet. Die im Beispiel 1 eingesetzten Bindemittel unterscheiden sich im elektronendonorhaltigen Monomeren ($A^1$) bis ($A^4$), im Beispiel 2 wird die Zusammensetzung der Copolymeren in weiten Grenzen variiert, und die im Beispiel 3 angeführten Bindemittel unterscheiden sich hauptsächlich im (Meth)acrylatanteil.

## Beispiel 1

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit Lösungen folgender Zusammensetzung überzogen:

9,44 Gt einer 53,2 %igen Lösung des Reaktonsprodukts von 1 mol 2,2,4-Trimethyl-hexamethylendiisocyanat und 2 mol Hydroxyethylmethacrylat in Methylethylketon,
5,03 Gt Bindemittel gemäß Tabelle 3,
0,162 Gt Eosin alkohollöslich (C.I. 45 386),
0,243 Gt 2,4-Bis-trichlormethyl-6-(4-styrylphenyl)-s-triazin und
0,396 Gt 9-Phenylacridin in
97,5 Gt Propylenglykolmonomethylether.

Das Auftragen erfolgte durch Aufschleudern in der Weise, daß ein Trockengewicht von 2,1 bis 2,5 g/m² erhalten wurde. Anschließend wurden die Platten zwei Minuten bei 100° C im Umlufttrockenschrank getrocknet. Die Platten wurden dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis 5 g/m² erhalten. Die erhaltenen Druckplatten wurden jeweils 20 Sekunden mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatten im sichtbaren Licht zu testen, wurden auf den Belichtungskeil jeweils 3 mm starke Kantenfilter der Firma Schott mit den in der Tabelle angege benen Kantendurchlässigkeiten montiert. Nach der Belichtung wurden die Platten eine Minute auf 100° C erwärmt. Anschließend wurden sie mit einem Entwickler folgender Zusammensetzung entwickelt:
120 Gt Natriummetasilikat • 9 $H_2O$,
2,13 Gt Strontiumchlorid,
1,2 Gt nichtionogenes Netzmittel (Kokosfettalkohol-Polyoxyethylenether mit ca. 8 Oxyethyleneinheiten) und
0,12 Gt Antischaummittel in
4000 Gt vollentsalztem Wasser.

Die Platte wurde mit fetter Druckfarbe eingefärbt. Es wurden die folgenden vollvernetzten Keilstufen erhalten:

Tabelle 3

| Verbindung | Graufilter | Kantenfilter (nm) | Keilstufen |
|---|---|---|---|
| 1 | ja | - | 6 |
| | nein | 455 | 7 |
| 2 | ja | - | 6 |
| | nein | 455 | 3 |
| 3 | ja | - | 4 |
| | nein | 455 | 5 |

Tabelle 3 (Fortsetzung)

| Verbindung | Graufilter | Kantenfilter (nm) | Keilstufen |
|---|---|---|---|
| 4 | ja | - | 3 |
| | nein | 455 | 8 |
| 5 | ja | - | 5 |
| | nein | 455 | 8 |
| 6 | ja | - | 5 |
| | nein | 455 | 4 |
| 7 | ja | - | 3 |
| | nein | 455 | 6 |
| 8 | ja | - | 5 |
| | nein | 455 | 9 |
| 9 | ja | - | 6 |
| | nein | 455 | 7 |
| 10 (V) | ja | - | 4 |
| | nein | 455 | 5 |
| 11 (V) | ja | - | 5 |
| | nein | 455 | 3 |
| 12 (V) | ja | - | 5 |
| | nein | 455 | 4 |

Tabelle 3 (Fortsetzung)

| Verbindung | Graufilter | Kantenfilter (nm) | Keilstufen |
|---|---|---|---|
| 13 | ja | - | 4 |
| | nein | 455 | 5 |
| 14 | ja | - | 5 |
| | nein | 455 | 3 |
| 15* | ja | - | 4 |
| | nein | 455 | 9 |
| 16* | ja | - | 5 |
| | nein | 455 | 7 |
| 17 | ja | - | 4 |
| | nein | 455 | 2 |

* aus Tetrahydrofuran aufgeschleudert

Beispiel 2

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,3 g/m$^2$ erhalten wurde:

9,44 Gt der in Beispiel 1 angegebenen Monomerlösung,
5,03 Gt Bindemittel gemäß Tabelle 4,
0,162 Gt Eosin alkohollöslich,
0,243 Gt des in Beispiel 1 angegebenen s-Triazins und
0,396 Gt 9-Phenylacridin in
97,5 Gt Propylenglykolmonomethylether

Die weitere Verarbeitung der Platten erfolgte analog zu Beispiel 1, wonach die in Tabelle 4 angegebene Anzahl vollvernetzter Keilstufen erhalten wurde.

Tabelle 4

| Verbindung | Graufilter | Kantenfilter (nm) | Keilstufen |
|---|---|---|---|
| 18 | ja | - | 7 |
| | nein | 455 | 8 |
| 19 | ja | - | 7 |
| | nein | 455 | 3 |
| 20 | ja | - | 4 |
| | nein | 455 | 9 |
| 21 | ja | - | 2 |
| | nein | 455 | 4 |

Tabelle 4 (Fortsetzung)

| Verbindung | Graufilter | Kantenfilter (nm) | Keilstufen |
|---|---|---|---|
| 22 | ja | - | 3 |
| | nein | 455 | 4 |
| 23 | ja | - | 2 |
| | nein | 455 | 4 |
| 24 | ja | - | 3 |
| | nein | 455 | 5 |
| 25 | ja | - | 5 |
| | nein | 455 | 8 |
| 26 | ja | - | 4 |
| | nein | 455 | 8 |
| 27 | ja | - | 5 |
| | nein | 455 | 8 |
| 28 | ja | - | 5 |
| | nein | 455 | 2 |
| 29 | ja | - | 3 |
| | nein | 455 | 5 |
| 30 | ja | - | 4 |
| | nein | 455 | 2 |

Tabelle 4 (Fortsetzung)

| Verbindung | Graufilter | Kantenfilter (nm) | Keilstufen |
|---|---|---|---|
| 31 | ja | - | 4 |
| | nein | 455 | 2 |
| 32 | ja | - | 3 |
| | nein | 455 | 6 |

Beispiel 3

Auf den in Beispiel 1 angegebenen Schichtträger wurden unter gleichen Bedingungen wie dort Lösungen gleicher Grundzusammensetzung wie in Beispiel 1 aufgeschleudert.

Die Platten wurden jeweils 20 Sekunden belichtet und sonst wie in Beispiel 1 verarbeitet, wonach die in Tabelle 5 angegebene Anzahl vollvernetzter Keilstufen erhalten wurde:

| Verbindung | Graufilter | Kantenfilter (nm) | Keilstufen |
|---|---|---|---|
| 33 | ja | - | 5 |
| | nein | 455 | 9 |
| 34 | ja | - | 5 |
| | nein | 455 | 10 |

Tabelle 4 (Fortsetzung)

| Verbindung | Graufilter | Kantenfilter (nm) | Keilstufen |
|---|---|---|---|
| 35 | ja | - | 6 |
| | nein | 455 | 11 |
| 36 | ja | - | 6 |
| | nein | 455 | 11 |
| 37 | ja | - | 5 |
| | nein | 455 | 10 |
| 38 | ja | - | 5 |
| | nein | 455 | 8 |
| 39 | ja | - | 4 |
| | nein | 455 | 8 |
| 40 | ja | - | 5 |
| | nein | 455 | 8 |
| 41 | ja | - | - |
| | nein | 455 | 5 |
| 42 | ja | - | 4 |
| | nein | 455 | 8 |

Beispiel 4

Auf den in Beispiel 1 angegebenen Schichtträger wurden unter gleichen Bedingungen wie dort Lösungen folgender Zusammensetzung so aufgeschleudert, daß ein Schichtgewicht von ca. 2,3 $g/m^2$ erhalten wurde:

2,52 Gt Monomeres gemäß Liste 1,
2,52 Gt Bindemittel wie in Tabelle 6 angegeben,
0,08 Gt Eosin alkohollöslich,
0,122 Gt des in Beispiel 1 angegebenen s-Triazins und
0,198 Gt 9-Phenylacridin in
48,75 Gt Propylenglykolmonomethylether.

Liste 1

Monomeres a: Hexandioldimethacrylat

Monomeres b: Pentaerythrittriacrylat

Monomeres c: Reaktionsprodukt von 1 mol 2,2,4-Trimethylhexamethylendiisocyanat mit 2 mol Hydroxyethylmethacrylat (4,74 Gt einer 53,2 %igen Lösung in Butanon)

Monomeres d: Hexamethylen-N,N′-bis-methacrylamid

Monomeres e: Trimethylolethantriacrylat

Monomeres f: Umsetzungsproduckt von 1 mol Triethanolamin und 3 mol Isocyanatoethylmethacrylat

Die Platten wurden wie in Beispiel 1 verarbeitet, wonach die in Tabelle 6 angegebene Anzahl vollvernetzter Keilstufen erhalten wurde:

Tabelle 6

| Polymeres | Monomeres | Belichtung (Sekunden) | Graufilter | Kantenfilter | Keilstufen |
|---|---|---|---|---|---|
| 3 | a | 5 | ja | - | 5 |
| | | 5 | nein | 455 | 8 |
| 3 | c | 20 | ja | - | 2 |
| | | 20 | nein | 455 | 5 |
| 3 | f | 20 | ja | - | 7 |
| | | 20 | nein | 455 | 7 |
| 4 | a | 20 | ja | - | 4 |
| | | 20 | nein | 455 | 8 |
| 4 | b | 20 | ja | - | 3 |
| | | 20 | nein | 455 | 5 |
| 4 | c | 20 | ja | - | 6 |
| | | 20 | nein | 455 | 9 |
| 33 | a | 20 | ja | - | 5 |
| | | 20 | nein | 455 | 8 |
| 33 | b | 20 | ja | - | 1 |
| | | 20 | nein | 455 | 6 |
| 33 | c | 20 | ja | - | 5 |
| | | 20 | nein | 455 | 10 |
| 33 | d | 20 | ja | - | 5 |
| | | 20 | nein | 455 | 6 |
| 33 | e | 20 | ja | - | 4 |
| | | 20 | nein | 455 | 7 |
| 40 | b | 20 | ja | - | 3 |
| | | 20 | nein | 455 | 9 |
| 40 | c | 20 | ja | - | 6 |
| | | 20 | nein | 455 | 10 |

Tabelle 6 (Fortsetzung)

| Polymeres | Monomeres | Belichtung (Sekunden) | Graufilter | Kantenfilter | Keilstufen |
|---|---|---|---|---|---|
| 40 | e | 20 | ja | - | 4 |
| | | 20 | nein | 455 | 8 |
| 40 | f | 20 | ja | - | - |
| | | 20 | nein | 455 | 5 |

Beispiel 5

Auf den in Beispiel 1 angegebenen Schichtträger wurden unter gleichen Bedingungen wie im Beispiel 1 Lösungen folgender Zusammensetzung so aufgeschleudert, daß Schichtgewichte von 2,3 $g/m^2$ erhalten wurden. Die Belichtungszeit betrug jeweils 20 Sekunden.

4,74 Gt des in Beispiel 1 angegebenen Monomeren,
2,52 Gt Bindemittel 4,
0,08 Gt Farbstoff gemäß Tabelle 7,
0,122 Gt des in Beispiel 1 angegebenen s-Triazins und
0,198 Gt 9-Phenylacridin in
48,75 Gt Propylenglykolmonomethylether.

Die Platten wurden in gleicher Weise wie in Beispiel 1 belichtet und entwickelt. Es wurde die folgende Anzahl vollvernetzter Keilstufen erhalten:

Tabelle 7

| Farbstoff (C.I. Nr.) | Graufilter | Kantenfilter | Keilstufen |
|---|---|---|---|
| Hämatoporphyrin | ja | - | 3 |
| | nein | 455 | 6 |
| Thionin | ja | - | 2 |
| (52 000) | nein | 455 | 1/2 |
| Cyanosin | ja | - | 4 |
| (45 410) | nein | 455 | 4 |
| 2,7-Dichlor-fluorescein | ja | - | 5 |
| | nein | 455 | 6 |
| Fluorescein | ja | - | 4 |
| (45350) | nein | 455 | 1 |
| Methylenblau | ja | - | 4 |
| (52 015) | nein | 455 | 1 |
| Eosin alkohollöslich | ja | - | 5 |
| (45 386) | nein | 455 | 8 |
| Bengalrosa B | ja | - | 4 |
| (45 440) | nein | 455 | 7 |
| Erythrosin | ja | - | 5 |
| (45 430) | nein | 455 | 8 |

Tabelle 7 (Fortsetzung)

| Farbstoff (C.I. Nr.) | Graufilter | Kantenfilter | Keilstufen |
|---|---|---|---|
| Pyronin GY | ja | - | 5 |
| (45 005) | nein | 455 | 1/2 |
| Rhodamin 6 G | ja | - | 5 |
| (45 160) | nein | 455 | - |
| 4-Amino- | ja | - | 5 |
| fluorescein | nein | 455 | 1 |

Beispiel 6

Auf den in Beispiel 1 angegebenen Schichtträger wurden wie dort beschrieben Lösungen folgender Zusammensetzung so aufgeschleudert, daß ein Schichtgewicht von 2,3 g/$m^2$ erhalten wurde:
3,304 Gt der in Beispiel 1 angegebenen Monomerlösung,
1,761 Gt Bindemittel 40,
0,057 Gt Eosin alkohollöslich,
0,256 Gt Halogenverbindung und
0,139 Gt 9-Phenylacridin in
37,2 Gt Propylenglykolmonomethylether.

Die Platten wurden in gleicher Weise wie im Beispiel 1 verarbeitet. Nach 20 Sekunden Belichtungszeit wurde die folgende Anzahl vollvernetzter Keilstufen erhalten:

Tabelle 8

| Halogenverbindung | Graufilter | Kantenfilter | Stufen |
|---|---|---|---|
| s-Triazin wie in Bsp. 1<br>s-Triazin wie in Bsp. 1 | ja<br>nein | -<br>455 | 5<br>7 |
| 2,4-Bis-trichlormethyl-6-(5-methoxynaphth-l-yl)-s-triazin | ja<br>nein | -<br>455 | 4<br>5 |
| 2,4-Bis-trichlormethyl-6-diphenyl-4-yl-s-triazin | ja<br>nein | -<br>455 | 3<br>8 |
| 2,4-Bis-trichlormethyl-6-phenyl-s-triazin | ja<br>nein | -<br>455 | 3<br>7 |
| 2,(4-Trichlormethylbenzoylmethylen)-3-ethylbenzthiazolin | ja<br>nein | -<br>455 | 5<br>3 |
| Phenyl-tribrommethylsulfon | ja<br>nein | -<br>455 | 2<br>5 |

Beispiel 7

Auf den in Beispiel 1 angegebenen Schichtträger wurden unter gleichen Bedingungen wie dort Lösungen folgender Zusammensetzung aufgeschleudert:
7,08 Gt der in Beispiel 1 angegebenen Monomerlösung,
3,77 Gt Bindemittel 40,
0,122 Gt Eosin alkohollöslich,
0,182 Gt 2,4-Bis-trichlormethyl-6-(4-styryl-phenyl)-s-triazin,
0,297 Gt 9-Phenylacridin und
0,31 Gt Carbonylverbindung in
73,1 Gt Propylenglykolmonomethylether
Die beschichteten Platten wurden wie im Beispiel 1 verarbeitet. Nach einer Belichtungszeit von 20 Sekunden wurde die folgende Anzahl vollvernetzter Keilstufen erhalten:

Tabelle 9

| Carbonylverbindung | Keilstufen | |
|---|---|---|
| | Graufilter | Kantenfilter (455 nm) |
| 4-Dimethylamino-4′-methoxydibenzalaceton | 4 | 8 |
| Carbonyl-bis-(7-diethylamino-cumarin) | 4 | 9 |
| ohne Zusatz | 3 | 7 |

Die beschichteren Platten wurden außerdem unter einem Interferenz-Verlauffilter von 400 bis 700 nm mit parallelem Licht einer 500 W-Glühbirne im Abstand von 75 cm 120 Sekunden belichtet. Nach Entwickeln wie in Beispiel 1 wurde in den angegebenen Spektralbereichen vollständige Aushärtung gefunden:

Tabelle 10

| Carbonylverbindung | Spektralbereich (nm) |
|---|---|
| 4-Dimethylamino-4′-methoxydibenzalaceton | 435-570 |
| Carbonyl-bis-(7-diethylamino-cumarin) | 450-470 und 490-570 |
| ohne Zusatz | 520-570 |

Die Wirksamkeit der zugesetzten Verbindungen hinsichtlich des Auflösungsvermögens wurde mit einer Testvorlage, dem FOGRA-PMS-Keil, bestimmt und an der Kopie abgelesen. Das oben angegebene Gemisch ohne Carbonylverbindung ergab eine um mindestens eine Stufe im K-Feld der Testvorlage schlechtere Auflösung.

Beispiel 8

Auf den in Beispiel 1 angegebenen Schichtträger wurden unter gleichen Bedingungen wie dort Lösungen folgender Zusammensetzung so aufgeschleudert, daß ein Schichtgewicht von 2,3 g/m$^2$ erhalten wurde:
9,44 Gt der in Beispiel 1 angegebenen Monomerlösung,
5,03 Gt Bindemittel gemäß Tabelle 11,
0,162 Gt Eosin alkohollöslich,
0,243 Gt 2,4-Bis-trichlormethyl-6-(4-styryl-phenyl)-s-triazin und
0,396 Gt 9-Phenylacridin in
97,5 Gt Propylenglykolmonomethylether.
Die Platten wurden in gleicher Weise wie im Beispiel 1 verarbeitet. Nach 20 Sekunden Belichtung

wurde jeweils die in Tabelle 11 angegebene Anzahl vollvernetzter Keilstufen erhalten:

Tabelle 11

| Polymeres | Keilstufen | |
|---|---|---|
| | Graufilter | Kantenfilter (455 nm) |
| A | 4 | 2 |
| C | 6 | 2 |
| F | 5 | 4 |
| G | 4 | 8 |

Im Unterschied zu den übrigen Beispielen wurden die Platten mit den Polymeren F und G mit einem Entwickler folgender Zusammensetzung entwickelt:
2,5 Gt Natriummetaphosphat,
1,5 Gt Poly-N-vinyl-N-methylacetamid,
2,8 Gt Pelargonsäure,
1,0 Gt KOH,
1,5 Gt Natrium-Dodecylbenzolsulfonat,
1,0 Gt Kaliumcarbonat,
1,0 Gt Kaliumhydrogencarbonat,
2,5 Gt 1-Phenylethanol
mit entionisiertem Wasser auf 100 Gt aufgefüllt.

## Ansprüche

1. Photopolymerisierbares Gemisch, das als wesentliche Bestandteile
a) ein polymeres Bindemittel,
b) einen Acryl- oder Alkacrylsäureester eines mehrwertigen Alkohols und
c) eine Verbindungskombination enthält, die unter Einwirkung von aktinischer Strahlung die Polymerisation der Verbindung (b) zu initiieren vermag,
dadurch gekennzeichnet, daß die Verbindungskombination (c)
c1) einen photoreduzierbaren Farbstoff und
c2) eine durch Strahlung spaltbare Trihalogenmethylverbindung enthält
und daß das Bindemittel (a) mindestens eine photooxydierbare Gruppe aufweist.

2. Photopolymerisierbares Gemisch nach Anspruch 1, dadurch gekennzeichnet, daß die photooxydierbare Gruppe eine Amino-, Thio- oder Stannylgruppe ist.

3. Photopolymerisierbares Gemisch nach Anspruch 1, dadurch gekennzeichnet daß das Bindemittel ein Molekulargewicht von 5.000 bis 1.000.000 hat.

4. Photopolymerisierbares Gemisch nach Anspruch 1, dadurch gekennzeichnet, daß das Bindemittel wasserunlöslich, aber in wäßrig-alkalischen Lösungen löslich ist.

5. Photopolymerisierbares Gemisch nach Anspruch 3, dadurch gekennzeichnet, daß der photoreduzierbare Farbstoff ein Xanthen-, Thiazin-, Pyronin-, Porphyrin-oder Acridinfarbstoff ist.

6. Photopolymerisierbares Gemisch nach Anspruch 3, dadurch gekennzeichnet, daß es ferner eine als Photoinitiator wirksame Acridin-, Phenazin-, Chinoxalin-oder Benzanthrachinonverbindung enthält.

7. Gemisch nach Anspruch 1, dadurch gekennzeichnet, daß die durch Strahlung spaltbare Trihalogenmethylverbindung ein s-Triazin, das durch mindestens eine Trihalogenmethylgruppe und eine weitere Gruppe substituiert ist, oder ein Aryltrihalogenmethylsulfon ist.

8. Gemisch nach Anspruch 7, dadurch gekennzeichnet, daß die weitere Gruppe mindestens einen aromatischen Kern enthält, der direkt oder über ein durchkonjugiertes Doppelbindungssystem mit dem Triazinrest verbunden ist.

9. Gemisch nach Anspruch 1, dadurch gekennzeichnet, daß der Acryl- oder Alkacrylsäureester mindestens zwei Acryl- oder Alkacrylsäureestergruppen enthält.

10. Photopolymerisierbares Gemisch nach Anspruch 1, dadurch gekennzeichnet, daß es 20 bis 90

Gew.-% Bindemittel (a), 10 bis 80 Gew.-% Acryl- oder Alkacrylsäureester (b) und 0,05 bis 20 Gew.-% lichtempfindliche Polymerisationsinitiatoren (c) enthält.

11. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß einem der Ansprüche 1 bis 10 besteht.